# EUROPÄISCHE PATENTSCHRIFT

(11) **EP 0 783 199 B1**
(45) Veröffentlichungstag und Bekanntmachung des Hinweises auf die Patenterteilung: **10.04.2002**
(21) Anmeldenummer: 97100097.1
(22) Anmeldetag: 07.01.1997
(51) Int. Cl.: H02H 7/00, H02M 7/00, H02G 5/00

(54) **Verschienungssystem für den Zwischenkreis eines Stromrichters**
Bus bar system for the intermediate circuit of a power converter
Système de barres conductrices pour le circuit intermédiaire d'un convertisseur

(30) Priorität: 08.01.1996 DE 19600367
(43) Veröffentlichungstag der Anmeldung: 09.07.1997
(73) Patentinhaber: DaimlerChrysler Rail Systems GmbH, 13627 Berlin (DE)
(72) Erfinder: Hilpert, Gerald, 79787 Lauchringen (DE); Schifferli, Rolf, 5318 Mandach (CH)
(74) Vertreter: Cohausz & Florack Patentanwälte

(56) Entgegenhaltungen:
- WO-A-94/14227
- WO-A-94/29885
- DE-A- 2 925 254

## Beschreibung

### Technisches Gebiet

Die Erfindung bezieht sich auf das Gebiet der Leistungselektronik. Sie geht aus von einem Verschienungssystem für den Zwischenkreis eines Stromrichters nach dem Oberbegriff des ersten Anspruchs.

### Stand der Technik

Ein solches Verschienungssystem wird z.B. im Artikel "GTO-Hochleistungsstromrichter für Triebfahrzeuge mit Drehstromantrieb", ABB Technik 4/1995, Seiten 4-13 beschrieben. Stromrichter z.B. für elektrisch angetriebene Lokomotiven weisen einen Gleichspannungszwischenkreis auf. An diesen Zwischenkreis ist einerseits ein Netzstromrichter - dieser fehlt, wenn das Netz ein Gleichspannungsnetz ist - und andererseits ein im allgemeinen mehrphasiger Antriebsstromrichter angeschlossen. Das Verschienungssystem bildet die elektrische Verbindung zwischen dem Ausgang des Netzstromrichters - oder dem Fahrdraht bei einem Gleichspannungsnetz - und den Leistungshalbleiterschaltern oder -modulen des Antriebsstromrichters.

Im Zuge der Entwicklung der Leistungshalbleiterschalter hat ein Übergang von konventionellen Thyristoren über die Abschaltthyristoren (GTOs) zu den IGBTs (Bipolartransistoren mit isoliertem Gate) stattgefunden. Die IGBTs sind im Allgemeinen in einem Modul integriert. Für höhere Leistungen werden mehrere Module parallel geschaltet. Im Hinblick auf Stromrichterfamilien verschiedener Leistungen wäre ein modularer und auf einfache Weise skalierbarer Aufbau des Stromrichters und somit auch des Verschienungssystems wünschenswert. Ausserdem sollte ein solches Verschienungssystem möglichst niederinduktiv aufgebaut sein, da aufgrund der immer höheren Anforderungen an eventuelle Netzrückwirkungen höhere Schaltfrequenzen bevorzugt werden.

Ein Verschienungssystem umfassend einen Plus- und einen Minusanschluss sowie Phazenanschlüsse, wobei die Polbleche und die Phasenanschlüsse in der Reihenfolge Plus anschluss, Minusanschluss, Phasen anschlüsse unter Zwischen fügung von Isolations elementen aufeinander gestapelt und auf einem Träger befestigt sind, ist aus WO-A-9 414 227 bekannt.

### Darstellung der Erfindung

Aufgabe der vorliegenden Erfindung ist es, ein Verschienungssystem anzugeben, welches einfach und niederinduktiv aufgebaut ist und welches im Hinblick auf verschiedene Leistungen einfach skalierbar ist. Diese Aufgabe wird bei einem Verschienungssystem der eingangs genannten Art durch die Merkmale des ersten Anspruchs gelöst.

Kern der Erfindung ist es also, dass der Plus- und Minusanschluss des Zwischenkreises je ein gitterförmiges Polblech umfassen und der oder die Phasenanschlüsse schienenförmig aufgebaut sind. Die Bleche und Schienen werden in der Reihenfolge Plus-, Minusanschluss, Phasenanschluss oder Minus-, Plusanschluss, Phasenanschluss unter Zwischenfügung von Isolationselementen aufeinander gestapelt auf einem Träger montiert.

Ein bevorzugtes Ausführungsbeispiel ist dadurch gekennzeichnet, dass die Polbleche im Bereich der Gitteraussparungen hochgebogene oder angeschweisste Laschen aufweisen, welche mit den ein "U"-förmiges Profil aufweisenden Schienen des oder der Phasenanschlüsse zusammenwirken. Dadurch können Leistungshalbleiterschalter oder -module durch einfaches Aufstecken auf die Laschen und die Schenkel der U-Schienen kontaktiert werden.

Dadurch, dass die Anzahl Aussparungen vergrössert wird, entstehen mehr Plätze für parallelgeschaltete Leistungshalbleiterschalter oder -module. Die Strombelastung des Stromrichters und damit die Leistung kann dadurch auf einfache Art und Weise eingestellt werden. Vorteilhaft an der Erfindung ist nicht nur die Tatsache, dass das Verschienungssystem leistungsmässig auf einfache Weise an Stromrichter verschiedener Leistung angepasst werden kann, sondern durch den flächigen Aufbau der Polbleche erhält man auch einen niederinduktiven Aufbau.

Weitere Ausführungsbeispiele ergeben sich aus den entsprechenden abhängigen Ansprüchen.

### Kurze Beschreibung der Zeichnungen

Nachfolgend wird die Erfindung anhand von Ausführungsbeispielen im Zusammenhang mit den Zeichnungen näher erläutert.

Es zeigen:
- **Fig. 1**: Eine Aufsicht auf ein erfindungsgemässes Verschienungssystem;
- **Fig. 2**: Das Verschienungssystem nach Figur 1 im Schnitt entlang der in Figur 1 strichpunktiert dargestellten Linie;
- **Fig. 3**: Eine Detailansicht eines erfindungsgemässen Verschienungssystems von der Seite;
- **Fig. 4**: Eine Aufsicht auf eine Phasenschiene;
- **Fig. 5**: Eine Aufsicht auf ein erstes Polblech;
- **Fig. 6**: Eine Aufsicht auf ein zweites Polblech.

Die in den Zeichnungen verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen.

### Wege zur Ausführung der Erfindung

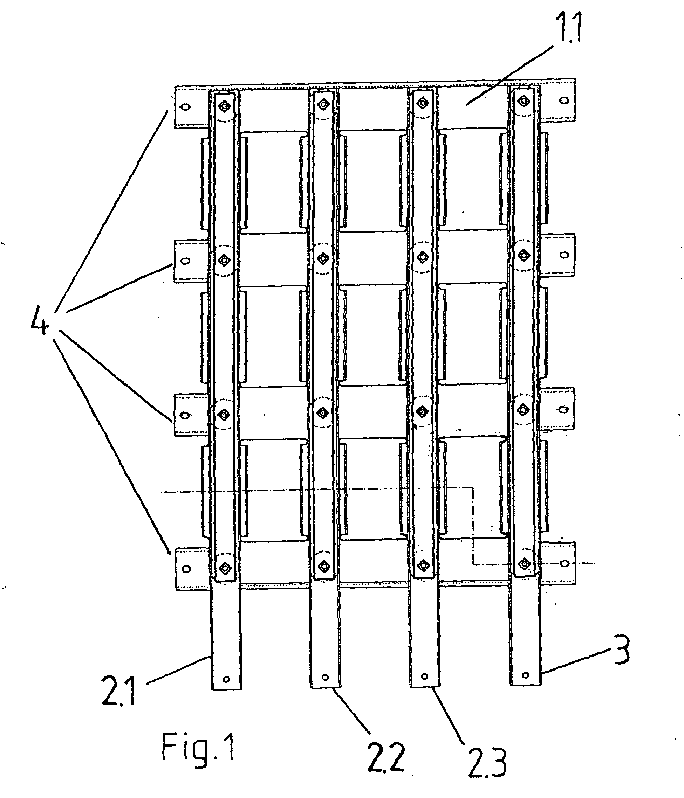

Figur 1 zeigt eine Aufsicht auf ein erfindungsgemässes Verschienungssystem. Dieses ist für die Zwischenkreisverschienung eines Stromrichters geeignet. Mittels der Zwischenkreisverschienung eines Stromrichters werden die elektrischen Kontakte zwischen dem Zwischenkreis eines U- oder I-Umrichters und den Leistungshalbleiterschaltern bzw. Leistungshalbleitermodulen und den Phasenbzw. Lastanschlüssen hergestellt. Figur 1 zeigt ein Ausführungsbeispiel einer Zwischenkreisverschienung eines dreiphasigen Stromrichters mit Bremssteller, wie er z.B. für Traktionsanwendungen eingesetzt wird.

Mit 4 ist ein Träger bezeichnet. Dieser kann z.B. aus einer Anzahl von Stahlträgern bestehen. Auf diesem Träger 4 sind zwei Polbleche 1.1 und 1.2 und drei Phasenschienen 2.1, 2.2, 2.3 sowie eine Bremsstelleranschlussschiene 3 in einer Stapelanordnung befestigt. Die Polbleche 1.1 und 1.2 führen zu den Gleichspannungs- oder Gleichstromanschlüssen des Zwischenkreises. Die Phasenschienen führen zu den Phasenanschlüssen der Last wie z.B. einem Antriebsmotor. Im folgenden wird nicht mehr zwischen Bremsstelleranschlussschiene und Phasenschiene unterschieden, da beide den gleichen mechanischen Aufbau aufweisen.

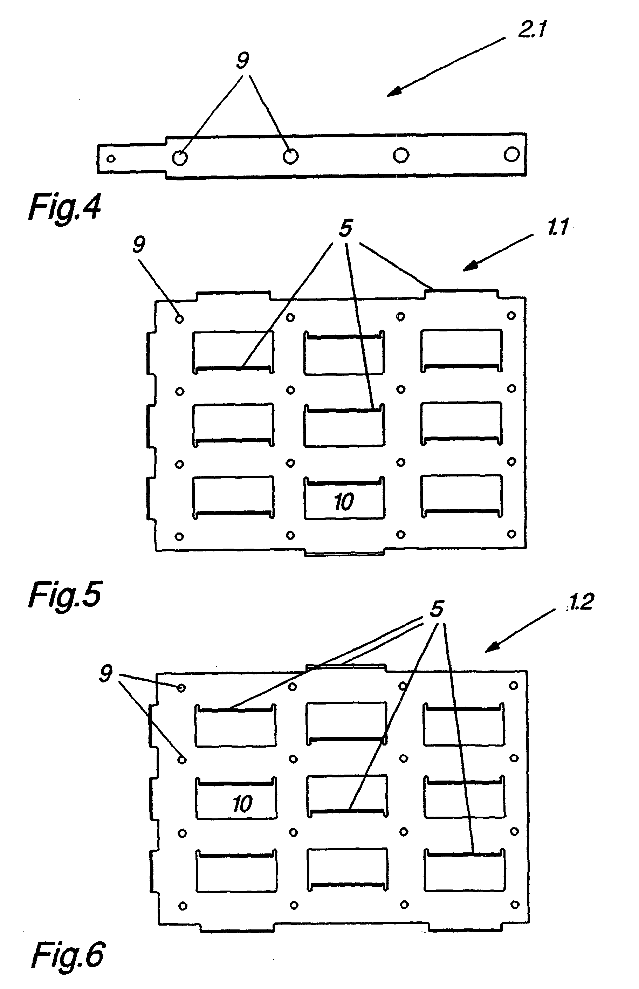

Die Figuren 5 und 6 zeigen die Polbleche 1.1 und 1.2 im Detail. Sie sind gitterförmig ausgestaltet und umfassen Aussparungen 10. Im Bereich der Aussparungen 10 und entlang der Seiten weisen die Polbleche 1.1 und 1.2 rechtwinklig abstehende, z.B. hochgebogene Laschen 5 auf. Für einen noch kompaktere Bauart können die Laschen auch angeschweisst sein. Man beachte, dass die beiden Polbleche 1.1 und 1.2 im Grunde denselben Aufbau aufweisen, aber verdreht montiert werden, indem das eine um 180° gedreht wird (im übrigen genau so, wie die Polbleche in den Figuren 5 und 6 dargestellt sind).

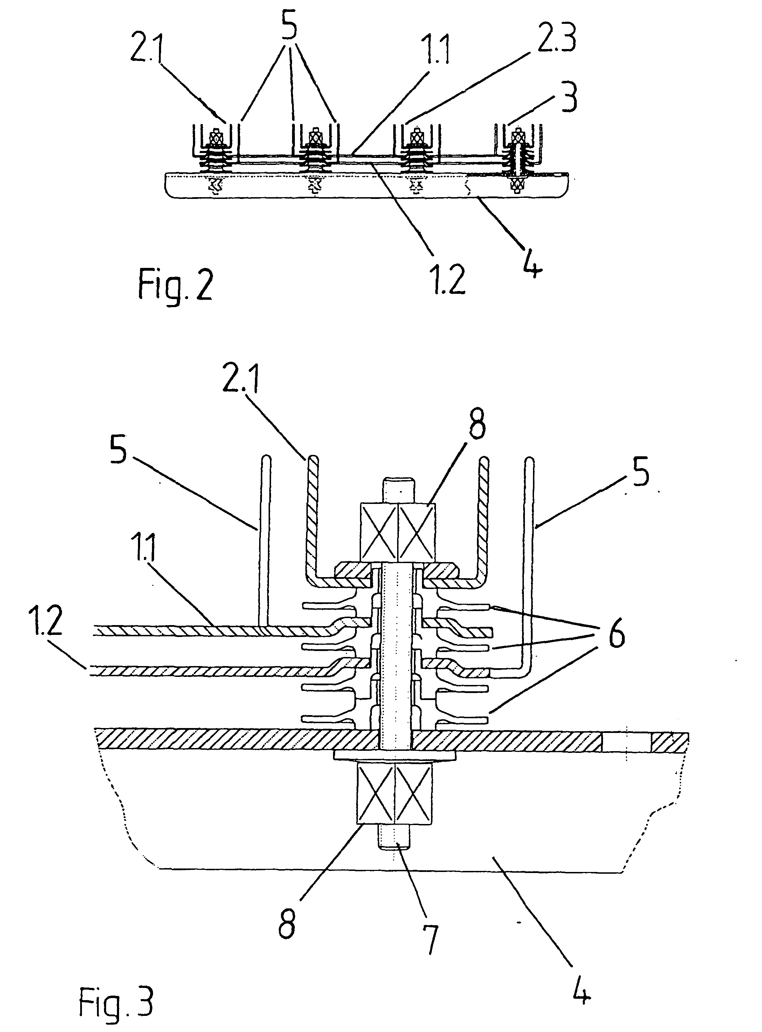

Die Phasenschienen weisen ein "U"-förmiges Profil auf. Auf der einen Seite verjüngen sie sich (siehe Figur 4). Polbleche und Phasenschienen werden nun aufeinander gestapelt und mit Schrauben oder Gewindestangen 7, welche durch entsprechende Befestigungslöcher 9 hindurchgeführt werden, auf dem Träger 4 befestigt. Dadurch ergibt sich eine Anordnung, wie sie in Figur 2 im Schnitt dargestellt ist. Der Abstand zwischen den Polblechen und Phasenanschlüssen wird so gewählt, dass kein Durchschlag erfolgen kann. Ausserdem sind, wie in der Detailansicht der Figur 3 gut zu sehen ist, wirbelförmige Isolationselemente oder Isolationsrosetten 6 zwischen den Polblechen und Phasenanschlüssen vorgesehen. Die Gewindestange 7 wird vorzugsweise aus einem elektrisch isolierenden Material, z.B. Kunststoff, gefertigt. Dasselbe gilt für die Muttern 8, mittels welcher der Stapel von Polblechen und Phasenschienen auf dem Träger festgeschraubt wird.

Durch die 180° Drehung des einen Polblechs bei der Montage, liegen in den Aussparungen immer je eine Lasche des einen Polblechs einer Lasche des anderen gegenüber. Dadurch ergibt sich im Schnitt (siehe Figur 3) folgende Abfolge der Laschen 5 bzw. "U"-Schenkel der Phasenanschlüsse: 1. Polblech, Phasenanschluss, Phasenanschluss, 2. Polblech. Dies ist genau die Reihenfolge, welche ein Aufstecken von mit entsprechenden Steckanschlüssen ausgerüsteten Leistungshalbleiterschaltern bzw. -modulen auf die Laschen bzw. "U"-Schenkel ermöglicht. In Figur 3 kann also sowohl links wie rechts der oberen Mutter 8 ein Schaltermodul bzw. Leistungshalbleiterschalter aufgesteckt werden. Dasselbe gilt natürlich entsprechend für die übrigen Anschlüsse (siehe Figur 3). Falls in einem Modul sogar ein ganzer Zweig einer Brückenschaltung integriert ist, kann auch nur ein mit entsprechenden Anschlüssen ausgestattetes Modul auf die 4 Laschen bzw. U-Schenkel aufgesteckt werden. Ein Schenkel der Phasenschienen könnte in diesem Fall sogar weggelassen werden.

Von oben gesehen weisen die Polbleche einen gitterförmigen Aufbau auf. Wie oben dargestellt wurde, wird über jeden Steg des Gitters mindestens ein Modul bzw. Schalter in die entsprechenden Anschlüsse der Polbleche und Phasenanschlüsse gesteckt. Dies erlaubt es, das Verschienungssystem an die Leistung eines Stromrichters anzupassen, indem es in den Figuren 5 und 6 von links nach rechts verlängert wird, so dass eine grössere Anzahl von Aussparungen entsteht. Dies ergibt ein Verschienungssystem, welches nach Figur 1 einfach nach oben verlängert ist. Es ist somit möglich, eine ganze Familie von Stromrichtern mit ähnlich aufgebauten Verschienungssystemen auszurüsten, indem dieses verlängert oder verkürzt wird.

Da die Polbleche im wesentlichen flächig aufgebaut sind, ergibt sich eine vergleichsweise kleine Induktivität. Dies ist insbesondere im Hinblick auf höhere Schaltfrequenzen und steilere Schaltflanken von grossem Vorteil.

Zusammengefasst kann gesagt werden, dass das erfindungsgemässe Verschienungssystem somit den Aufbau eines Stromrichter erlaubt, welcher nicht nur niederinduktiv aufgebaut ist, sondern auch auf einfache Art und Weise leistungsmässig skaliert werden kann.

### Bezugszeichenliste

- 1.1, 1.2: Polbleche
- 2.1, 2.2, 2.3: Phasenschienen
- 3: Bremsstelleranschluss
- 4: Träger
- 5: Lasche
- 6: Isolierelement
- 7: Gewindestange
- 8: Mutter
- 9: Befestigungsloch
- 10: Aussparung

## Patentansprüche

1. Verschienungssystem für eine Zwischenkreisverschienung eines Stromrichters, umfassend einen Plus- und einen Minusanschluss sowie mindestens einen Phasenanschluss, wobei der Plus- und der Minusanschluss aus einem gitterförmigen, mit Aussparungen (10) versehenen Polblech (1.1, 1.2) bestehen, dass der oder jeder Phasenanschluss schienenförmig ausgebildet ist und wobei die Polbleche (1.1, 1.2) und die schienenförmigen Phasenanschlüsse (2.1,..,2.3) in der Reihenfolge Plusanschluss, Minusanschluss, Phasenanschluss/ Phasenanschlüsse oder Minusanschluss, Plusanschluss, Phasenanschluss/Phasenanschlüsse unter Zwischenfügung von Isolationselementen (6) aufeinander gestapelt und auf einem Träger (4) befestigt sind.

2. Verschienungssystem nach Anspruch 1, wobei die Stege der gitterförmigen Polbleche (1.1, 1.2) im Bereich der Aussparungen (10) im wesentlichen rechtwinklig abstehende Laschen (5) aufweisen, wobei der oder jeder schienenförmige Phasenanschluss (2.1,..,2.3) im wesentlichen ein "U-förmiges Profil aufweist und wobei die Laschen (5) der Polbleche (1.1, 1.2) mit den benachbarten Schenkeln des "U"-förmigen Phasenanschlusses zur Aufnahme und elektrischen Kontaktierung von Leistungshalbleiterschaltern oder Leistungshalbleiterschaltermodulen zusammenwirken.

3. Verschienungssystem nach Anspruch 1 oder 2, wobei eine Anzahl der Aussparungen (10) der Polbleche nach Massgabe der Anzahl Phasenanschlüsse und einer geforderten Leistung des Stromrichters bzw. einer Anzahl parallelgeschalteter Leistungshalbleiterschalter oder Leistungshalbleiterschaltermodulen gewählt ist.

4. Stromrichter, insbesondere U-Umrichter, mit einen Zwischenkreis und daran angeschlossenen Brückenzweigen, wobei die elektrische Verbindung zwischen den Brückenzweigen und dem Zwischenkreis ein Verschienungssystem nach einem der vorstehenden Ansprüche umfasst.

## Claims

1. A bus bar system for an intermediate circuit bus bar of a power converter, including a plus and a minus connection as well as at least one phase connection, wherein the plus and minus connections comprise a grid-shaped pole junction strip (1.1, 1.2) provided with recesses (10), the or each phase connection is implemented in a rail shape and the pole junction strips (1.1, 1.2) and the rail-shaped phase connections (2.1, ..., 2.3) are stacked on one another in the sequence plus connection, minus connection, phase connection/phase connections or minus connection, plus connection, phase connection/phase connections, with insulation elements (6) being interposed, and are affixed to a carrier (4).

2. A bus bar system according to claim 1, wherein the ribs of the grid-shaped pole junction strips (1.1, 1.2) have essentially perpendicularly projecting tabs (5) in the region of the recesses (10), the or each rail-shaped phase connection (2.1, ..., 2.3) essentially has a U-shaped profile, and the tabs (5) of the pole junction strips (1.1, 1.2) work together with the neighboring legs of the U-shaped phase connections for the accommodation and electrical contact of power semiconductor switches or power semiconductor switch modules.

3. A bus bar system according to claim 1 or 2, wherein a number of the recesses (10) of the pole junction strips is selected according to the number of phase connections and a required power of the converter and/or a number of power semiconductor switches or power semiconductor switch modules connected in parallel.

4. A converter, particularly a U-converter, having an intermediate circuit and bridge arms connected to it, wherein the electrical connection between the bridge arms and the intermediate circuit includes a bus bar system according to one of the preceding claims.

## Revendications

1. Système de conduction par rail pour la conduction par circuit intermédiaire d'un convertisseur, comportant un raccordement positif et un raccordement négatif ainsi qu'au moins un raccordement phasé, le raccordement positif et le raccordement négatif consistant en une plaque de polarisation en forme de grille (1.1, 1.2) munie d'évidements (10), le ou chacun des raccordements phasés étant conçu en forme de rail et les tôles de pôles (1.1, 1.2) et les raccordements phasés en forme de rail (2.1, ..., 2.3) étant empilés les uns sur les autres dans l'ordre raccordement positif, raccordement négatif, raccordement phasé/raccordements phasés ou raccordement négatif, raccordement positif, raccordement phasé/raccordements phasés avec intercalage d'éléments isolants (6) et étant fixés sur un support (4).

2. Système de conduction par rail selon la revendication 1, les traverses des tôles de pôles en forme de grille (1.1, 1.2) présentant, dans le secteur des évidements (10), des pattes saillantes (5) globalement à angle droit, le ou chacun des raccordements phasés en forme de rail (2.1, ..., 2,3) présentant globalement un profil en forme de « U » et les pattes (5) des tôles de pôles (1.1, 1.2) agissant conjointement avec les branches voisines du raccordement en forme de « U » pour la réception et le contact électrique de commutateurs de puissance ou modules de commutateurs de puissance.

3. Système de conduction par rail selon la revendication 1 ou 2, le nombre d'évidements (10) des tôles de pôles étant défini au prorata du nombre de raccordements phasés et d'une puissance requise du convertisseur ou d'un nombre de commutateurs de puissance ou modules de commutateurs de puissance branchés en parallèle.

4. Convertisseur, en particulier convertisseur en U, avec un circuit intermédiaire et des branches de pont connectées à celui-ci, la liaison électrique entre les branches de pont et le circuit intermédiaire comprenant un système de conduction par rail selon une des revendications précédentes.
